# EUROPEAN PATENT APPLICATION

(11) **EP 1 873 877 A1**
(43) Date of publication of application: **02.01.2008**
(21) Application number: 07104974.6
(22) Date of filing: 27.03.2007
(51) Int. Cl.: H01S 5/0683, G02B 26/12

(54) **Laser scanning device and image forming device including the laser scanning device**

(30) Priority: 27.06.2006 KR 20060058284
(71) Applicant: Samsung Electronics Co., Ltd., Suwon-si, Gyeonggi-Do (KR)
(72) Inventor: Lee, Jong-min, Suwon-si Gyeonggi-do (KR)
(74) Representative: Walaski, Jan Filip

(57) **Abstract**

A laser scanning device and an image forming device including the laser scanning device are provided. The laser scanning device includes: a laser diode (LD)(120) driver arranged to control a driving signal supplied to a laser diode (LD) (130); and a power source unit (110) arranged to delay a current supplied from a bias power source for a predetermined period of time to remove a surge current transmitting to the LD driver. The laser scanning device further includes: a ferrite bead (150) arranged to filter the surge current of the driving signal supplied from the LD driver to the laser diode (LD); and a diode (160) connected to the laser diode (LD) in parallel to conduct an inverse surge current flowing from a ground port toward the LD driver. As a result, the laser diode (LD) can be prevented from being deteriorated by surge currents.

## Description

This invention relates to a laser scanning device, and more particularly, to a laser scanning device capable of cutting off a surge current of a current flowing into a laser diode (LD) so as to prevent the laser diode (LD) from being deteriorated, and an image forming device including such a laser scanning device.

In general, image forming devices, such as laser printers, facsimile machines, photo-copiers and multi-functional products, perform laser scanning operations using one or more laser diodes (LDs) during exposure processes. Components of such image forming devices that perform laser scanning operations are known as laser scanning units (LSUs) or laser scanning devices.

Typically, a laser scanning device includes a laser diode (LD), a photodiode (PD), and an LD driver. The LD driver supplies a driving signal to the laser diode (LD) to drive the laser diode (LD). Thus, a laser signal is scanned to a photosensitive body, such as a photosensitive drum. The photodiode (PD) is disposed to measure an intensity of the laser signal scanned from the laser diode (LD). Thus, the photodiode (PD) provides a feedback signal having an intensity corresponding to the intensity of the laser signal to the LD driver. The LD driver compares the feedback signal with a predetermined reference signal to adjust an intensity of the driving signal. As a result, the laser signal may be kept in a predetermined intensity.

Generally, a laser diode (LD) used in an image forming device quickly operates at a low current and a low voltage. Thus, the laser diode (LD) is vulnerable to a surge current which momentarily flows into the laser diode (LD) during a supply of a power. In other words, if a surge current having a pulse width of about 1µms flows into the laser diode (LD), the laser diode (LD) emits an excessive light power in response to the surge current. As a result, a surface of a light emission point of the laser diode (LD) can be optically damaged. The laser diode (LD) is deteriorated, and thus a quality of an image is deteriorated.

Several aspects and example embodiments of the present invention provide a laser scanning device capable of removing a surge current flowing into a laser diode (LD) to prevent the laser diode (LD) from being deteriorated, and an image forming device including the laser scanning device.

Additional aspects and/or advantages of the invention will be set forth in part in the description which follows and, in part, will be obvious from the description, or may be learned by practice of the invention.

In accordance with an example embodiment of the present invention, there is provided a laser scanning device including: a laser diode (LD); an LD driver arranged to control a driving signal supplied to the laser diode (LD); and a power source unit arranged to delay a current supplied from a bias power source for a predetermined period of time to remove a surge current and transmit the current to the LD driver.

According to an aspect of the present invention, the laser scanning device may further include a bead arranged to filter the surge current of the driving signal supplied from the LD driver to the laser diode (LD). A first end of the bead may be connected to an output port of the LD driver, and a second end of the bead may be connected to an anode of the LD.

According to an aspect of the present invention, the laser scanning device may further include a photodiode (PD) arranged to output a feedback signal corresponding to an intensity of a laser signal scanned from the laser diode (LD) to the LD driver. The LD driver may compare the feedback signal with a predetermined reference signal to adjust an intensity of the driving signal.

According to an aspect of the present invention, the power source unit may include: at least one capacitor charged with the current supplied from the bias power source; and at least one transistor turned on to transmit the current to the LD driver if the at least one capacitor is charged.

According to another aspect of the present invention, the power source unit may include: a resistor having one end connected to the bias power source; a first transistor having a collector is connected to the bias power source and a base connected to a second end of the resistor; a second transistor having a collector is connected to the bias power source, a base connected to an emitter of the first transistor, and an emitter connected to an input port of the LD driver; a first capacitor connected between the base of the first transistor and a ground port; and a second capacitor connected between the emitter of the second transistor and the ground port.

According to yet another aspect of the present invention, the laser scanning device may further include a diode connected to the LD in parallel to induce an inverse surge current flowing from the ground port toward the LD driver. Such a laser scanning device can be applied to an image forming device for forming images.

In accordance with another example embodiment of the present invention, there is provided an image forming device comprising: a laser scanning unit having at least a laser diode (LD) to scan a laser beam onto a photosensitive body so as to form a latent image thereon, a LD driver to control a driving signal supplied to the laser diode (LD), and a power source unit to delay a current supplied from a bias power source for a predetermined period of time to remove a surge current transmitting to the LD driver; and a control unit arranged to control a scanning speed of the laser scanning unit when the laser scanning unit forms the latent image on the photosensitive body.

In addition to the example embodiments and aspects as described above, further aspects and embodiments will be apparent by reference to the drawings and by study of the following descriptions.

A better understanding of the present invention will become apparent from the following detailed description of example embodiments and the claims when read in connection with the accompanying drawings, all forming a part of the disclosure of this invention. While the following written and illustrated disclosure focuses on disclosing example embodiments of the invention, it should be clearly understood that the same is by way of illustration and example only and that the invention is not limited thereto. The scope of the present invention is limited only by the terms of the appended claims. The following are brief descriptions of the drawings, wherein:
Figure 1 is a schematic block diagram illustrating an example of the structure of a laser scanning device according to an embodiment of the present invention;
Figures 2 and 3 are views illustrating a detailed structure of the laser scanning device shown in Figure 1;
Figures 4A and 4B are current waveforms illustrating an operation of removing a surge current in a power source unit shown in Figure 1:
Figures 5A and 5B are current waveforms illustrating an operation of filtering a surge current in a bead shown in Figure 3; and
Figures 6A and 6B are current waveforms illustrating an operation of inducing an inverse surge current in a laser diode (LD) shown in Figure 3.

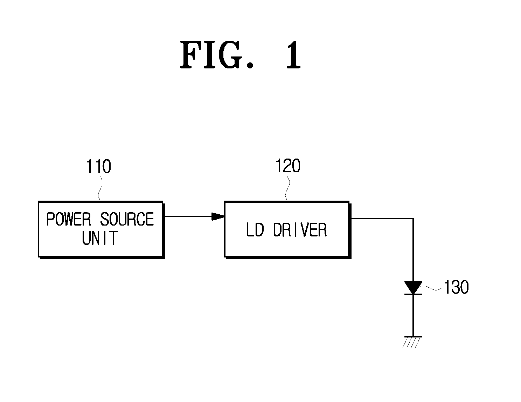

Reference will now be made in detail to the accompanying drawings, wherein like reference numerals refer to the like elements throughout. Figure 1 is a schematic block diagram illustrating an example of the structure of a laser scanning device according to embodiment of the present invention. Such a laser scanning device is included in an image forming device, such as a laser printer, a facsimile machine, a photocopier or a multi-functional product. However, for purposes of simplicity, the image forming device according to the embodiment of the present invention described herein, is a laser printer.

Referring to Figure 1, the laser scanning device comprises a power source unit 110, a laser diode (LD) driver 120, and an LD 130. Detailed structures such as mirrors, lenses, motors, sensors, etc. used in a laser scanning operation are not shown in Figure 1 for the sake of brevity. However, a generally basic structure of the laser scanning device can be utilized.

The LD 130 produces a laser signal in the form of an optical beam, and the laser signal is scanned onto a surface of a photosensitive body or the like. The LD 130 is electrically driven by the LD driver 120. The LD driver 120 supplies a driving signal having a predetermined intensity to the LD 130 so that the LD 130 produces the laser signal. In this case, an intensity of the laser signal, i.e., an intensity of a light power, corresponds to the predetermined intensity of the driving signal. If the predetermined intensity of the driving signal is increased, the intensity of the laser signal is increased. If the predetermined intensity of the driving signal is decreased, the intensity of the laser signal is decreased.

The power source unit 110 transmits a current, which flows in from a bias power source Vcc, to the LD driver 120 so that the LD driver 120 controls the laser diode (LD) 130. In this case, the power source unit 110 does not directly transmit the current provided from the bias power source Vcc to the LD driver 120, but rather delays the current for a predetermined period of time and then transmits the current to the LD driver 120. Therefore, a surge current flowing in from the bias power source Vcc is absorbed and removed during the delaying. Thus, a current having a stable intensity is supplied to the LD driver 120.
As a result, the LD 130 is prevented from being deteriorated.

The power source unit 110 includes one or more capacitors and one or more transistors arranged to delay the current. In detail, the power source unit 110 may be realized in a structure in which one or more capacitors are charged with the current supplied from the bias power source Vcc, and thus one or more transistors are turned on by a voltage charged into the at least one capacitors so as to supply the current to the LD driver 120. A detailed structure of the power supply source 110 will be described below.

The laser scanning device shown in Figure 1 may be applied to an image forming device, such as a printer, a facsimile machine, a scanner, or a multi-functional product which forms images or images of a texts on various media such as a paper sheet or the like. An image forming device according to an embodiment of the present invention may use the laser scanning device shown Figure 1 in an exposure operation to form a latent image on a photosensitive body. The image forming device may include various engines including, for example, a charging unit, a transferring unit, a developing unit, a fusing unit, a feeding unit, and the like and controller units including a video controller and the like. However, since the structures and functions of these elements, except the laser scanning device, are well known, their detailed illustrations and descriptions will be omitted for the sake of brevity.

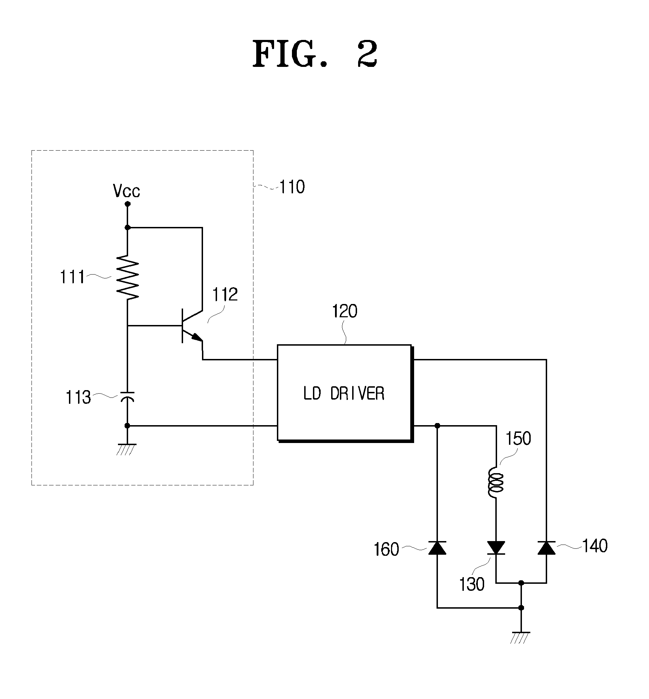

Figure 2 is a schematic view illustrating a detailed structure of the laser scanning device. Referring to Figure 2, the laser scanning device includes the power source unit 110, the LD driver 120, the LD 130, a photodiode 140, a bead 150, and a diode 160.

The power source unit 110 shown in Figure 2 includes a resistor 111 connected to a bias power source Vcc, a transistor 112, and a capacitor 113. The resistor 111 and the capacitor 113 are connected in series between the bias power source Vcc and a ground port. The transistor 112 can be, but not limited to, a NPN-type of bipolar transistor that is arranged in parallel with the resistor 111. Such a transistor 112 has a collector connected to the bias power source Vcc, a base disposed between the resistor 111 and the capacitor 113, and an emitter coupled to an input port of the LD driver 120. Since the capacitor 130 is discharged in an initial state, a voltage less than a threshold voltage is applied to the base of the transistor 112. Thus, since the transistor 112 is kept turned off, a current supplied from the bias power source Vcc flows toward the capacitor 113. As a result, the capacitor 113 is charged. If the capacitor 113 is charged and thus a difference between potentials of both ends of the capacitor 113 is greater than or equal to the threshold voltage, the transistor 112 is turned on. Thus, a current supplied from the bias power source Vcc to the collector of the transistor 112 is transmitted to an emitter of the transistor 112 as it is and then output to the LD driver 120. As a result, the supply of the current is delayed, while the capacitor 113 is charged. Therefore, an initial excess current, i.e., a surge current, is prevented from being transmitted to the LD driver 120 as it is. In other words, the surge current is removed.

The bead 150 may be further included between an output port of the LD driver 120 and the laser diode (LD) 130. The bead 150 may be realized so that a line through which a driving signal advances penetrates a Ferrite core having a tube shape. When the driving signal output from the LD driver 120 passes the bead 150, a noise component and the like are filtered due to a self attenuation effect of ferrite. As a result, noise and the like mixed in the driving signal output from the LD driver 120 may be filtered.

Referring to Figure 2, the diode 160 may be connected to the laser diode (LD) 130 in parallel. In other words, the diode 160 is disposed so that a cathode of the diode 160 is connected to the output port of the LD driver 120, and an anode of the diode 160 is connected to a ground port. In this case, an inverse surge current inversely flowing from the ground port is induced toward the LD driver 120 through the diode 160 connected to the ground port in a forward direction. Thus, the inverse surge current may be prevented from flowing toward the laser diode (LD) 130 so as to prevent the laser diode (LD) 130 from being deteriorated. The LD driver 120 is much more stable with respect to the inverse surge current than the laser diode (LD) 130 and thus is not deteriorated by the inverse surge current.

The photodiode (PD) 140 transmits a feedback signal corresponding to an intensity of a laser signal output from the laser diode (LD) 130 to the LD driver 120. The LD driver 120 compares the feedback signal with a pre-set reference signal. If the feedback signal is greater than the pre-set reference signal, the LD driver 120 lowers an intensity of the driving signal. If the feedback signal is smaller than the pre-set reference signal, the LD driver 120 increases the intensity of the driving signal. To perform these operations, the LD driver 120 includes a voltage comparator (not shown) and an automatic power controller (APC) (not shown). The structure and operation of the LD driver 120 are well known. As a result, their detailed descriptions will be omitted herein.

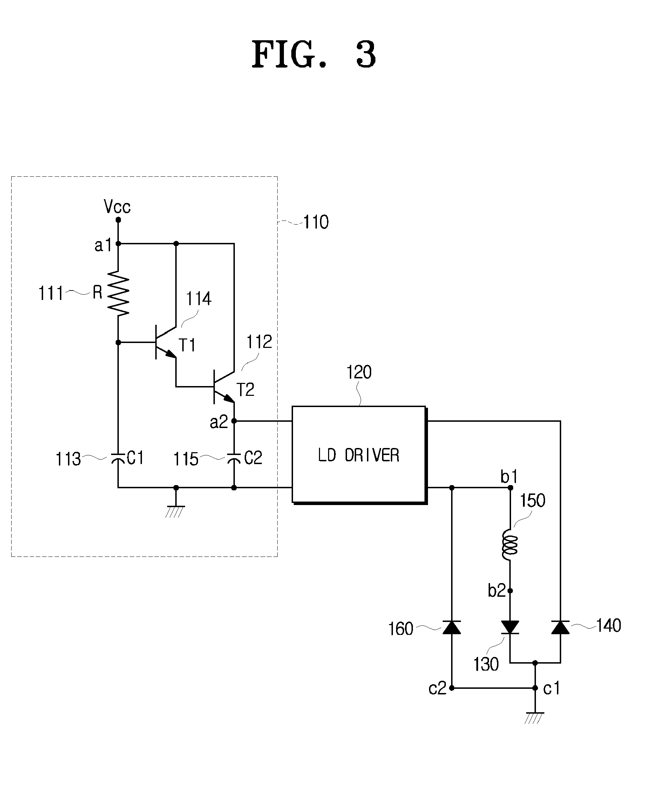

Figure 3 is a schematic view illustrating a detailed structure of the laser scanning device according to another example embodiment of the present invention. Referring to Figure 3, the power source unit 110 includes a resistor 111, two transistors 112 (**T1**) and 114 **(T2),** and two capacitors 113 (**C1**) and 115 **(C2).** Hereinafter, for the sake of convenience, the two transistors **T1** and **T2** are referred to as first and second transistors 114 and 112, and the two capacitors **C1** and **C2** are referred to as first and second capacitors 113 and 115.

As shown in Figure 3, the resistor 111 and the capacitor 113 are connected in series between the bias power source Vcc and a ground port. Both the first transistor 114 and the second transistor 112 can be, but are not limited to, NPN-type of bipolar transistors that are arranged in parallel with the resistor 111. For example, the first transistor 114 has a collector connected to the bias power source Vcc, and a base disposed between the resistor 111 and the capacitor 113. The second transistor 112 has a collector connected to the bias power source Vcc, a base connected to an emitter of the first transistor 114 and an emitter connected to one end of the second capacitor 115 and an input port of the LD driver 120.

The first capacitor 113 is connected between the first transistor 114 and a ground port, and the second capacitor 115 is connected between the emitter of the second transistor 112 and the ground port. Thus, while the first and second capacitors 113 and 115 are charged, the first and second transistors 114 and 112 are kept turned off. If the first and second capacitors 113 and 115 are completely charged, and thus the first and second transistors 114 and 112 are turned on, a current supplied from the bias power source **Vcc** is transmitted to the LD driver 120. As a result, a surge current is absorbed and removed.

The laser diode (LD) 130, the photodiode 140, the bead 150, the diode 160, and the LD driver 120, as shown in Figure 3, have already been described with reference to Figure 2. As a result, their detailed descriptions will be omitted hereinafter. The laser scanning devices illustrated in Figures 2 and 3 may be utilized in an image forming device.

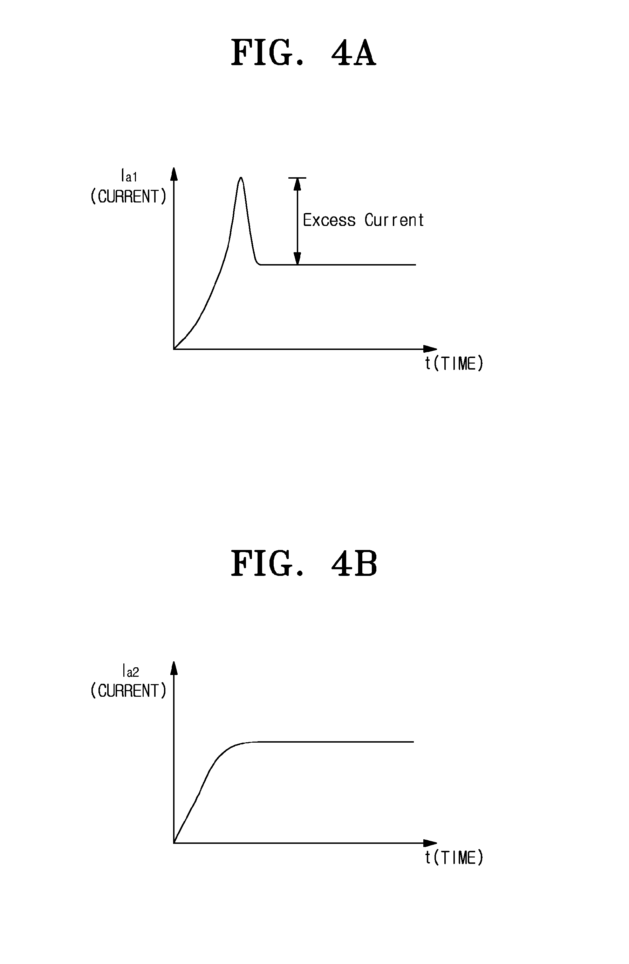

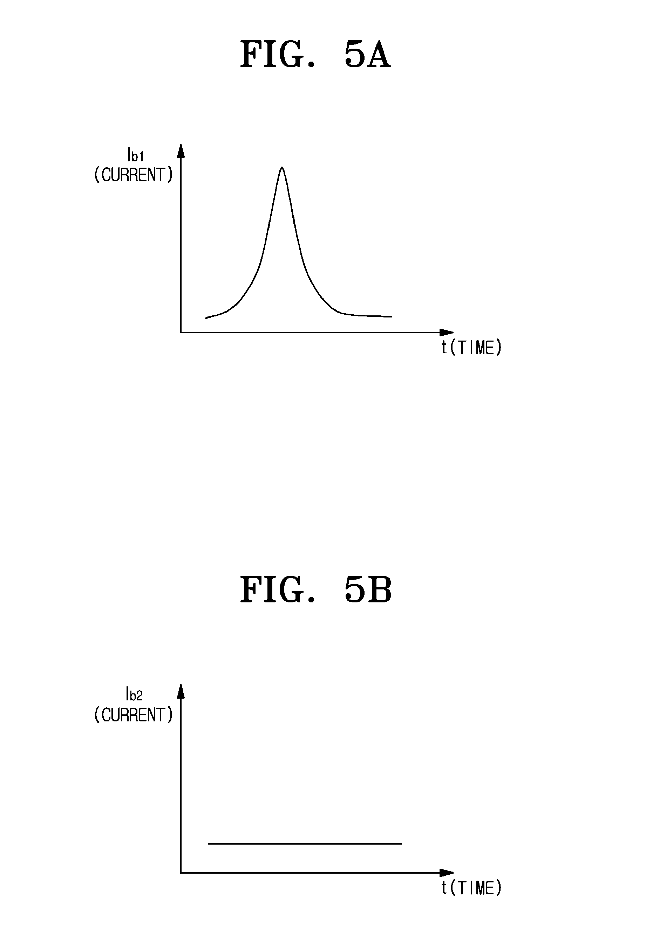

Figures 4A, 4B, 5A, and 5B are waveforms illustrating a process of removing a surge current from the laser scanning device shown in Figure 3. Figure 4A illustrates a waveform of a current flowing in a node **a1** of the power source unit 110, as shown in Figure 3. Referring to Figure 4A, an excess current is generated at an initial current inflow stage, and then a current having a stable intensity is maintained. Figure 4B illustrates a waveform of a current flowing in a node **a2** of the power source unit 110, as shown in Figure 3. Referring to Figure 4B, when the first and second capacitors 113 and 115 are charged and discharged, an excess current is absorbed, and thus a current having a constant intensity is transmitted to the LD driver 120 as it is.

Figure 5A illustrates noise of a surge form flowing in an output node **b1** of the LD driver 120, as shown in Figure 3. The noise is filtered through the bead 150 due to the characteristic of ferrite, and thus a stable current as shown in Figure 5B is transmitted to the LD 130. The stable current shown in Figure 5B is a current flowing in a node **b2** shown in Figure 3.

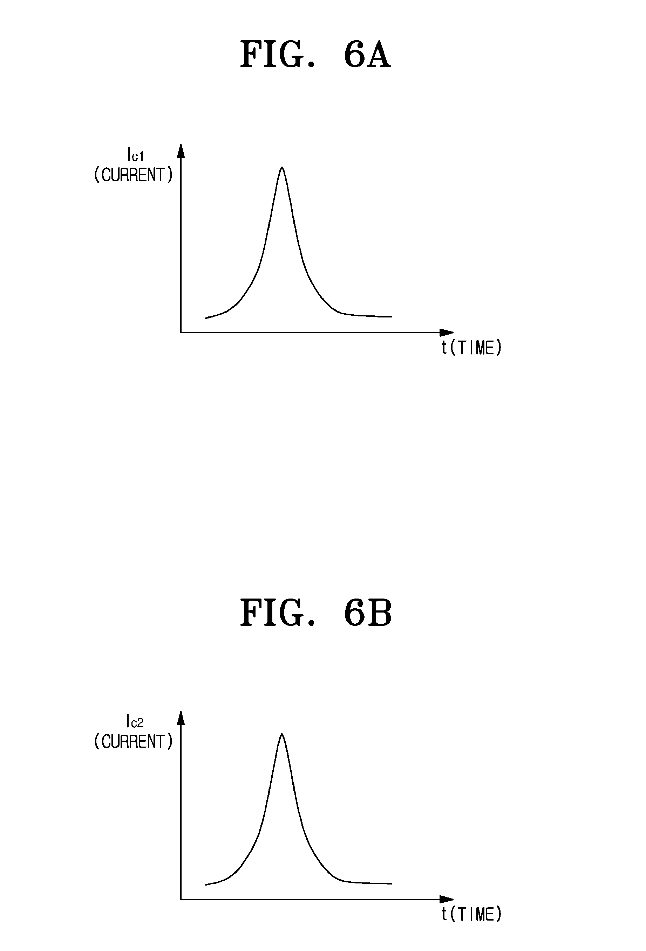

Figure 6A illustrates a waveform of an inverse surge current leaking from the ground port connected to the laser diode (LD) 130. In other words, Figure 6A illustrates a waveform of a current flowing in a node **c1** shown in Figure 3. The inverse surge current is induced toward the LD driver 120 through the diode 160 connected to the ground port in the forward direction. Thus, the laser diode (LD) 130 is not affected by the inverse surge current. Figure 6B illustrates a waveform of a current flowing in a node **c2** of an anode of the diode 160. The waveform of the current flowing in the node **c2** is equal to the waveform of the current of the node **c1,** and thus the inverse surge current is induced to the diode 160 as it is.

It has been described that bipolar transistors are shown in Figures 2 and 3. However, MOS transistors may be used to realize a circuit having the same structure as circuits shown in Figures 2 and 3. Similarly, different types of transistors such as PNP transistors can also be utilized. In addition, one or two transistors and one or two capacitors are shown in FIGS 2 and 3. However, the power source unit 110 may be designed using three or more transistors and three or more capacitors.

As described above, in a laser scanning device and an image forming device including the laser scanning device according to example embodiments of the present invention, a surge current flowing into a laser diode (LD) can be cut off. In detail, a current supplied from a power source can be delayed to be removed. Also, a surge current generated by malfunctions of internal components of an LD driver can be removed using a bead. In addition, an inverse surge current flowing from a ground port can be prevented from flowing into the laser diode (LD). Thus, the laser diode (LD) can be prevented from being deteriorated.

Various components of the power source unit 110 and the laser diode (LD) arrangement, as shown in Figure 2 and Figure 3, can be arranged differently, or alternatively, can be implemented in software or hardware, such as, for example, an application specific integrated circuit (ASIC). As such, it is intended that the processes described herein be broadly interpreted as being equivalently performed by software, hardware, or a combination thereof. As previously discussed, software modules can be written, via a variety of software languages, including C, C++, Java, Visual Basic, and many others. These software modules may include data and instructions which can also be stored on one or more machine-readable storage media, such as dynamic or static random access memories (DRAMs or SRAMs), erasable and programmable read-only memories (EPROMs), electrically erasable and programmable read-only memories (EEPROMs) and flash memories; magnetic disks such as fixed, floppy and removable disks; other magnetic media including tape; and optical media such as compact discs (CDs) or digital video discs (DVDs). Instructions of the software routines or modules may also be loaded or transported into the wireless cards or any computing devices on the wireless network in one of many different ways.

While embodiments of the present invention have been described herein by way of illustrative example, it will be understood by those skilled in the art and as technology develops that various changes and modifications, may be made, and equivalents may be substituted for elements thereof without departing from the true scope of the present invention. Many modifications, permutations, additions and sub-combinations may be made to adapt the teachings of the present invention to a particular situation without departing from the scope thereof. For example, components of an image forming apparatus and a laser scanning device can be arranged differently as long as a surge current can be controlled according to the principles of the present invention. In addition, one or more laser diodes (LDs) may be used to emit multiple laser beams; however, surge current can be prevented in the same manner as described with reference to Figure 2 and Figure 3. Further, other laser sources may be used in lieu of one or more laser diodes (LD) used to emit laser beams. Similarly, the laser scanning unit control circuit and the engine driving circuit can be incorporated into existing components of the image forming apparatus, such as a system controller. Moreover, such a system controller can be implemented as a chipset having firmware, or alternatively, a general or special purposed computer programmed to implement surge current preventing techniques as described with reference to Figure 2 and Figure 3. Accordingly, it is intended, therefore, that the present invention not be limited to the various embodiments disclosed by way of example, but that the present invention includes all embodiments falling within the scope of the appended claims.

## Claims

1. A laser scanning device comprising:
a laser diode (LD)(130);
an LD driver (120) arranged to control a driving signal supplied to the laser diode (LD); and
a power source unit (110) arranged to delay a current supplied from a bias power source (Vcc) for a given period of time and transmit the current to the LD driver.

2. The laser scanning device as claimed in claim 1, further comprising a inhibiting means (150) arranged to filter the surge current of the driving signal supplied from the LD driver to the laser diode (LD).

3. The laser scanning device as claimed in claim 2, wherein the surge inhibiting means (150) comprises a bead having a first end connected to an output port of the LD driver, and a second end connected to an anode of the laser diode (LD).

4. The laser scanning device as claimed in any preceding claim, further comprising:
a photodiode (PD) (140) arranged to output a feedback signal corresponding to an intensity of a laser signal scanned from the laser diode (LD) to the LD driver,
wherein the LD driver is operable to compare the feedback signal with a predetermined reference signal to adjust an intensity of the driving signal.

5. The laser scanning device as claimed in any preceding claim, wherein the power source unit (110) comprises:
at least one capacitor (113, 115) charged with the current supplied from the bias power source; and
at least one transistor (112, 114) turned on to transmit the current to the LD driver if the at least one capacitor is charged.

6. The laser scanning device as claimed in claim 5, wherein the power source unit comprises:
a resistor (111) having a first end connected to the bias power source (Vcc);
a first transistor (114) having a collector connected to the bias power source and a base connected to a second end of the resistor;
a second transistor (112) having a collector connected to the bias power source, a base connected to an emitter of the first transistor, and an emitter connected to an input port of the LD driver;
a first capacitor (113) connected between the base of the first transistor and a reference potential; and
a second capacitor (115) connected between the emitter of the second transistor and the ground port.

7. The laser scanning device as claimed in any preceding claim, further comprising a diode (160) arranged in parallel to the laser diode (LD) to conduct an inverse surge current flowing from the ground port toward the LD driver.

8. An image forming apparatus including a laser scanning device as claimed in any preceding claim.

9. The image forming device as claimed in claim 8, comprising:
a laser scanning unit wherein the laser diode (LD) is configured to scan a laser beam onto a photosensitive body so as to form a latent image thereon; and
a control unit arranged to control a scanning speed of the laser scanning unit when the laser scanning unit forms the latent image on the photosensitive body.
